# EUROPEAN PATENT APPLICATION

(11) **EP 1 569 287 A2**
(43) Date of publication of application: **31.08.2005**
(21) Application number: 05004110.2
(22) Date of filing: 25.02.2005
(51) Int. Cl.: H01L 51/30

(54) **Organic light emitting device materials and organic light emitting devices**

(30) Priority: 26.02.2004 JP 2004051641
(71) Applicant: FUJI PHOTO FILM CO., LTD., Kanagawa-ken, 250-0193 (JP)
(72) Inventor: Nishio, Ryo, Minami-Ashigara-shi Kanagawa (JP)
(74) Representative: HOFFMANN EITLE

(57) **Abstract**

A light-emitting device that has a layer formed from a compound represented by formula (1) : 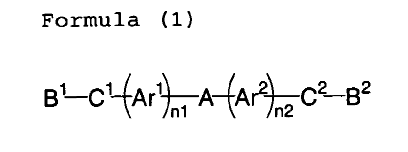 In formula (1), A represents a heterocyclic ring having at least one heteroatom and Ar¹ and Ar² each independently represent an aromatic ring provided that A, Ar¹, and Ar² each may have a substituent; B¹ and B² each independently represent a polymerizable substituent; C¹ and C² each independently represent a linear, branched, or cyclic linking group having 1 to 20 carbon atoms; and n1 and n2 each represent an integer of 0, 1, or 2 provided that n1 and n2 do not both represent 0 at the same time.

## Description

### BACKGROUND OF THE INVENTION

### 1. Field of the Invention

The present invention relates to a light-emitting device and, particularly, to a light-emitting device which is stable with respect to heat and possesses excellent light-emitting and polarization characteristics.

### 2. Description of the Related Art

Examples of introducing a crosslinking group into a fluorescent liquid crystal molecule, orienting the obtained material while in a state as a thin film and then photopolymerizing the same can be found in publication (for example, refer to "Chem. Mater. ", 2002, vol. 14, No. 4, p 1477).

However, the properties of this material render it insufficient for practical use, and there has thus been demand for development of a light-emitting device having both excellent light-emitting and polarization characteristics.

### SUMMARY OF THE INVENTION

The present invention has been made in view of the above circumstances and provides a light-emitting device which is stable with respect to heat, can be produced easily, and possesses excellent light-emitting characteristics and polarization characteristics (polarized light-emission or the like) .

An aspect of the invention is to provide a light-emitting device comprising a layer formed from a compound represented by formula (1): 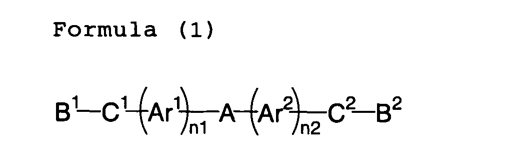 wherein A represents a heterocyclic ring having at least one heteroatom, and Ar¹ and Ar² each independently represent an aromatic ring, provided that A, Ar¹, and Ar² each may have a substituent; B¹ and B² each independently represent a polymerizable substituent; C¹ and C² each independently represent a linear, branched, or cyclic linking group having 1 to 20 carbon atoms, and one or more -CH₂- in the linking group may be substituted with -O-, -CO-, -NH-, -NR-, -CH=CH-, or -C =C- provided that the one or more -CH₂- are not adjacent to a heteroatom; R represents an alkyl group having 1 to 20 carbon atoms, and one or more -CH₂- in the alkyl group may be substituted with -O-, -CO-, -CH=CH-, or -C≡C- provided that the one or more -CH₂- are not adjacent to a heteroatom; and n1 and n2 each independently represent an integer of 0, 1, or 2 provided that n1 and n2 do not both represent 0 at the same time.

### BRIEF DESCRIPTION OF THE DRAWINGS

Fig. 1 is a schematic view showing a cross section of an embodiment of a light-emitting device according to the invention.
Fig. 2 is a schematic view showing a cross section of another embodiment of the light-emitting device according to the invention.
Fig. 3 is a schematic view showing a cross section of still another embodiment of the light-emitting device according to the invention.
Fig. 4 is a schematic view showing a cross section of still a further embodiment of the light-emitting device according to the invention.
Fig. 5 is a schematic view showing a cross section of a still further embodiment of a light-emitting device according to the invention.
Fig. 6 is a graph showing polarization brightness (light-emitting intensity) in horizontal and vertical directions with respect to the polarization axis of a polarization plate (vs: wavelength) at the time of polarized emission of the light-emitting device according to the invention.

### DETAILED DESCRIPTION OF THE INVENTION

The light-emitting device according to the present invention comprises a layer formed from a compound represented by formula (1) (The compound in the invention means monomeric and polymeric form both.) given below (hereinafter, also referred to as "light-emitting layer").

The light-emitting layer in the invention is formed from a compound represented by the following formula (1). Further, the compound represented by formula (1) is preferably a compound represented by the following formula (2).

The light-emitting layer may further include another polymeric medium, a spacer such as a granulated substance/sealant, an orientation controlling agent, another liquid crystalline compound, a polymerization initiator, a crosslinking agent, etc.

The compound represented by formulae (1) and (2) and polymers thereof will be described in detail below. *Compound represented by formulae (1) and (2)*

The light-emitting layer in the invention contains a compound represented by the following formula (1) and its polymeric form.

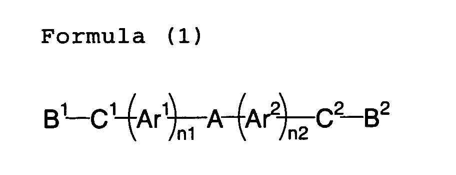

In formula (1), A represents a heterocyclic ring having at least one heteroatom, and Ar¹ and Ar² each independently represent an aromatic ring, provided that A, Ar¹ and Ar² each may have a substituent; B¹ and B² each independently represent a polymerizable substituent; C¹ and C² each independently represent a linear, branched, or cyclic linking group having 1 to 20 carbon atoms, and one or more -CH₂- in the linking group may be substituted with -O-, -CO-, -NH-, -NR-, -CH=CH-, or -C ≡C- provided that the one or more -CH₂- are not adjacent to a heteroatom; R represents an alkyl group having 1 to 20 carbon atoms, and one or more -CH₂- in the alkyl group may be substituted with -O-, -CO-, -CH=CH-, or -C≡C- provided that the one or more -CH₂- are not adjacent to a heteroatom; and n1 and n2 each independently represent an integer of 0, 1, or 2 provided that n1 and n2 do not both represent 0 at the same time.

The content of the compound represented by formula (1) in the total components to form light-emitting layer is, preferably, from 60 to 100 mass%, more preferably, from 80 to 100 mass%.

Further, the compound represented by formula (1) is, preferably, a compound represented by the following formula (2).

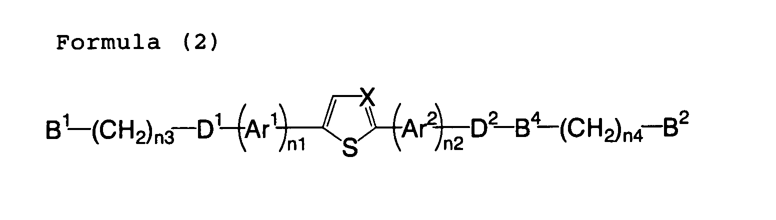

In formula (2), X represents a nitrogen atom or CH; Ar¹ and Ar² each independently represent an aromatic ring; B¹ and B² each independently represent a polymerizable substituent; n1 and n2 each independently represent an integer of 0, 1, or 2 provided that n1 and n2 do not both represent 0 at the same time; n3 and n4 each independently represent an integer from 1 to 20; D¹ and D² each independently represent a single bond, -O-, -COO-, -OCO-, -NH-, -NR-, -NRCO-, -CONR-, -NHCO-, or -CONH-; R represents an alkyl group having 1 to 20 carbon atoms, and one or more -CH₂- in the alkyl group may be substituted with -O-, -CO-, -CH=CH-, or -C≡C- provided that the one or more -CH₂- are not adjacent to a heteroatom; and B⁴ represents a single bond or an alkylene group having 2 to 10 carbon atoms which may be further substituted with an alkyl group.

In formula (1), A represents a heterocyclic ring having at least one heteroatom. A is preferably a single ring, double ring, or fused heterocyclic ring. Preferred examples thereof include, thiophene-2,5-diyl, thiazole-2,5-diyl, thiadiazole-2,5-diyl, pyridine-2,5-diyl, pyrimidine-2,5-diyl, pyrazine-2,5-diyl, pyridazine-3,6-diyl, quinoline-2,6-diyl, benzofuran-2,5-diyl, benzofuran-2,6-diyl, 2,2'-bithiazole-5,5'-diyl. Among them, more preferred examples include thiophene-2,5-diyl, thiazole-2,5-diyl, thiadiazole-2,5-diyl, pyridine-2,5-diyl, pyrimidine-2,5-diyl, pyrazine-2,5-diyl, pyridazine-3,6-diyl. A is particularly preferably thiophene-2,5-diyl or thiazole-2,5-diyl. The ring represented by A may have one or two substituents at arbitrary positions. Preferred examples of such a substituent include an alkyl group having 1 to 8 carbon atoms, an alkoxy group and a halogen atom. Among them, more preferred examples include an alkyl group having 1 to 4 carbon atoms (such as methyl group, ethyl group, n-propyl group, i-propyl group, n-butyl group, i-butyl group, sec-butyl group, and tert-butyl group).

In formulae (1) and (2), Ar¹ and Ar² each independently represent an aromatic ring. Preferred examples include 1,4-phenylene, thiophene-2,5-diyl, 2,6-naphthalene, thiazole-2,5-diyl, pyridine-2,3-diyl, benzofuran-2,5-diyl, benzofuran-2,6-diyl, benzothiophene-2,5-diyl, benzothiophene-2,6-diyl, pyrimidine-2,5-diyl, pyrazine-2,5-diyl, pyridazine-3,6-diyl. Among them, more preferred examples include 1,4-phenylene, 2,6-naphthalene, thiophene-2,5-diyl and thiazole-2,5-diyl. Ar¹ and Ar² may have one or more substituents at arbitrary positions and preferred examples thereof include an alkyl group having 1 to 8 carbons, an alkoxy group and a halogen atom. Among them, more preferred examples include an alkyl group having 1 to 4 carbon atoms (for example, methyl group, ethyl group, n-propyl group, i-propyl group, n-butyl group, i-butyl group, sec-butyl group, tert-butyl group).

In formulae (1) or (2) B¹ and B² each represent a polymerizable substituent. Preferred examples of B¹ and B² include polyethyleneoxy group, acryloyloxy group, methacryloyloxy group, glycidyl group, vinyloxy group, epoxy group and oxetane group.

In formula (1), C¹ and C² each independently represent a linear, branched, or cyclic linking group having 1 to 20 carbon atoms. One or more -CH₂- in the linking group may be substituted with -O-, -CO-, -NH-, -NR-, -CH=CH-, or -C≡C-provided that the one or more -CH₂- are not adjacent to a heteroatom. In a case where the linking group has a tertiary carbon atom, the carbon atom may be substituted with a nitrogen atom. R is an alkyl group having 1 to 20 carbon atoms, and one or more -CH₂- in the alkyl group may be substituted with -O-, -CO-, -CH=CH-, or -C≡C- provided that the one or more -CH₂- are not adjacent to a heteroatom. Preferred examples of C¹ and C² include a linear alkylene group having 2 to 16 carbon atoms, polyethyleneoxy group having 2 to 14 carbon atoms, and substituents shown below. Particularly preferred examples include a linear alkyl group having 4 to 12 carbon atoms and a linear alkyloxy group.

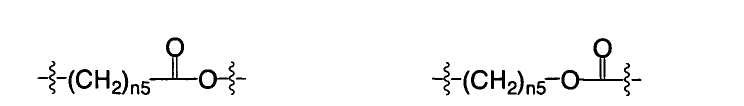

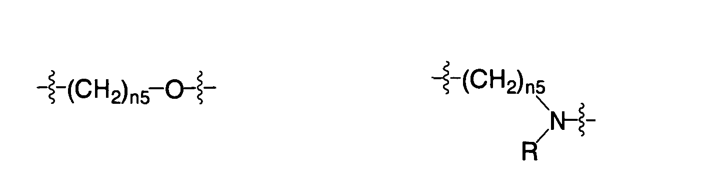

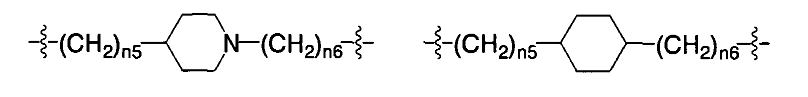

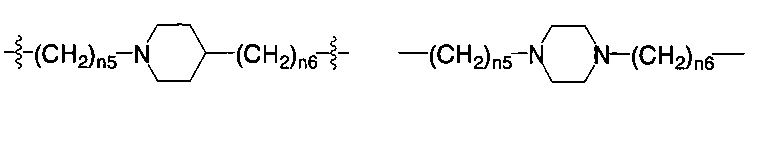

In the substituents described above, each of the substituents illustrated above is connected on the right side with the aromatic ring Ar¹ or Ar² and on the left side with B¹ or B². n5 and n6 each independently represent an integer from 0 to 14, preferably an integer from 0 to 10. R represents an alkyl group having 1 to 20 carbon atoms.

In formula (2), D¹ and D² each independently represent a single bond, -O-, -COO-, -OOC-, -NH-, -NR-, -NRCO-, -CONR-, -NHCO-, or -CONH-. R is an alkyl group having 1 to 20 carbon atoms, and one or more -CH₂- in the alkyl group may be substituted with -O-, -CO-, -CH=CH-, or -C≡C- provided that the one or more -CH₂- are not adjacent to a heteroatom. Here, preferred examples of R include a linear alkyl group having 1 to 20 carbon atoms, or a substituent identical with that bonded to another side of the nitrogen atom (that is, B¹-(CH₂)ₙ₃-, or B²-(CH₂)ₙ₄-).

In formula (2), B⁴ represents a single bond or an alkylene group having 2 to 10 carbon atoms which may be substituted with an alkyl group.

The compound represented by formula (1) described above preferably exhibits liquid crystallinity and, more preferably, a smectic phase or nematic phase. The liquid crystal phase described above may have chirality, and a preferred liquid crystal phase in this case includes, cholesteric (chiral nematic) phase, chiral smectic phase, twist grain boundary (TGB) phase, etc.

Preferred examples of the compound represented by formula (1) according to the invention are shown below.

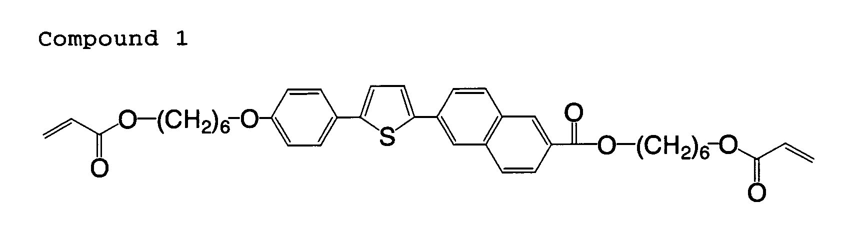

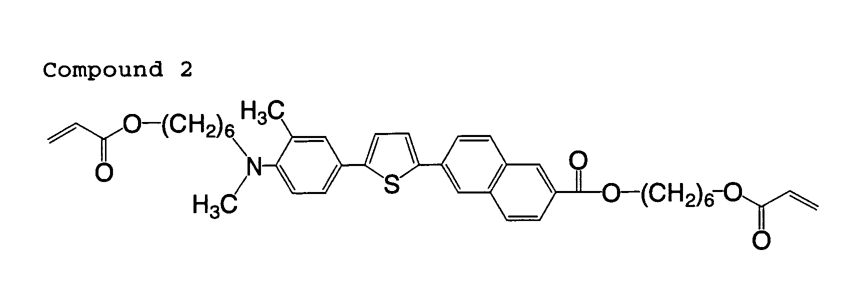

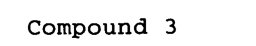

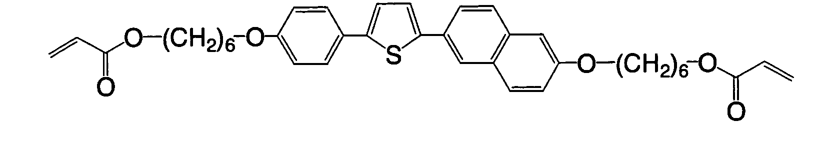

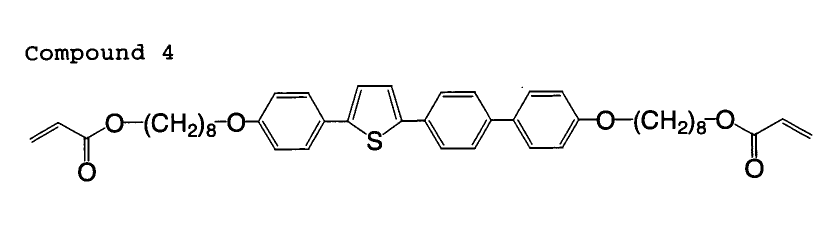

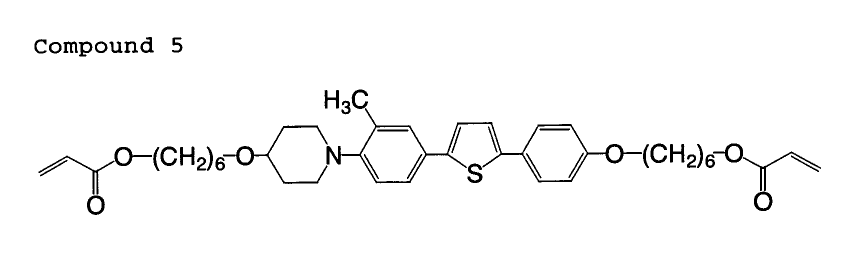

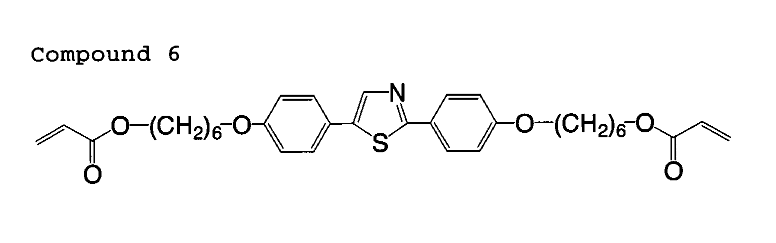

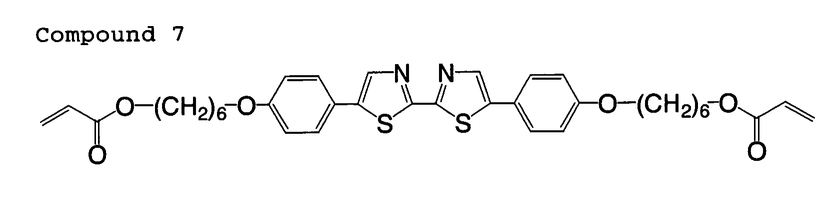

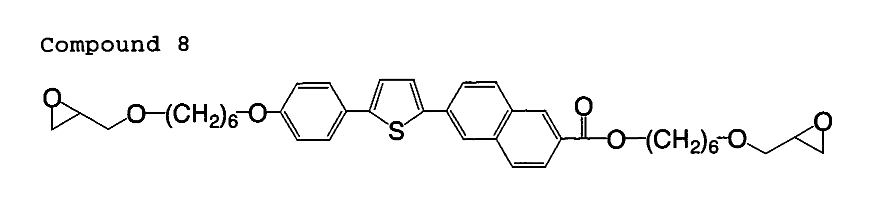

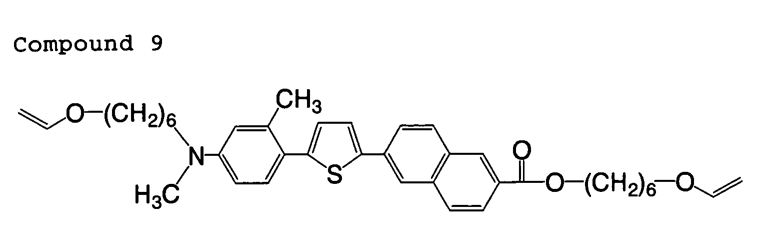

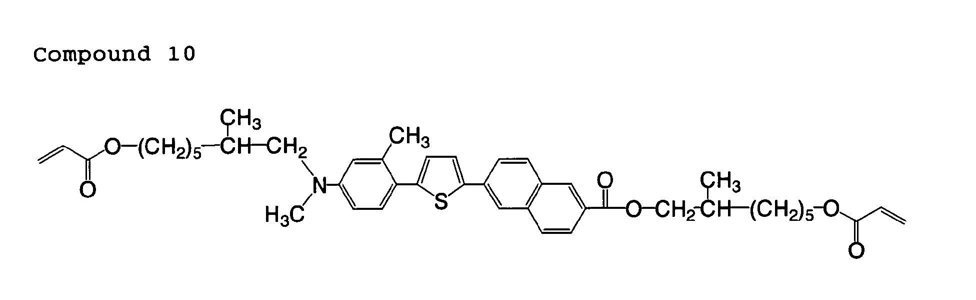

The compound represented by formula (1) used in the invention can be synthesized by a known synthesis method (refer, for example, to European Patent Application Publication No. 1 394 158 A1).

The light-emitting layer in the light-emitting device of the invention contains the compound represented by formula (1) as a main component and may also contain other components. The light-emitting layer preferably has a single-layer structure obtained by polymerization of a single compound, and acts as a shield against oxygen or moisture in the air so that sealing of the device is not required. Accordingly, the light-emitting device of the invention is highly suited to manufacturing, since the manufacture thereof is simple, convenient, and can be done at a reduced cost owing to the simple structure of the device.

The light-emitting device according to the invention includes a layer formed from the compound represented by formula (1). The layer can be obtained by polymerizing the compound represented by formula (1) alone or in a mixture with other material(s), while in a state as a film, to effect three-dimensional crosslinking.

Due to the three-dimensional crosslinking through polymerization, the film is strong and can maintain its light-emitting characteristic stably despite external conditions such as heat or impact shock. Further, the compound represented by formula (1) is preferably a compound exhibiting liquid crystallinity (hereinafter, also referred to as "liquid crystalline compound"). When the compound represented by formula (1) is a liquid crystalline compound, the molecules of the compound can be oriented while in a liquid crystal state and polymerized, and thereby the molecules become crosslinked three-dimensionally. As a result, the state of orientation can be retained, making it possible to maintain and improve light-emitting characteristics, and also attain polarization characteristics.

The reason for this is that the compound represented by formula (1) exhibits liquid crystallinity, and by polymerizing the compound while in a liquid crystal state, three-dimensional crosslinking through the polymerizing reaction is possible while maintaining a high order parameter.

A light-emitting device with a crosslinked film maintaining a high order parameter has higher light extraction efficiency than a light-emitting device in which the molecules are not oriented at all or which has a low order parameter. Further, light exhibits higher polarization the higher the order the parameter is of a light-emitting device by which the light is extracted. Thus a light-emitting device having a higher order parameter is useful as a polarized light-emitting device.

As described above, of the compounds represented by formula (1), a compound exhibiting a uniaxially oriented liquid crystal phase is further preferred. "Uniaxially oriented liquid crystal phase state" means a state where the compound represented by formula (1) is in a state of being a mono-domain orientation (distinguishable with a polarization microscope or X-ray analysis) in which the axes of orientation of the molecules are in an identical direction. The direction of the axes of orientation may be perpendicular, horizontal, or inclined with respect to the electrodes. Since a uniaxially oriented light-emitting device has higher symmetry of its axes of orientation than one in a poly-axial state of orientation, higher polarized emission and light extraction efficiencies can be expected.

Next, a method of preparing a light-emitting device including a layer formed from the compound represented by formula (1) will be described, but the method of introducing the layer may be any method and is not restricted.

For example, the method of preparing the light-emitting device according to the invention is as shown below.
(1) A compound represented by formula (1) is dissolved alone or together with other material in an appropriate solvent, (2) the solution is coated on a substrate with a transparent electrode (anode), (3) the solvent is evaporated to dry, (4) polymerizing reaction is conducted, and (5) a counter electrode (cathode) is provided.

In a case where the compound represented by formula (1) exhibits liquid crystallinity, preparation of the device by the following method is preferred in view of the preparation of a device having a high order parameter. (1) The compound represented by formula (1) is dissolved alone or together with other material into an appropriate solvent, (2) the solvent is coated onto a substrate having a transparent electrode (anode), (3) the solvent is evaporated to dry, (4) a state of orientation is formed at a temperature at which the liquid crystal state is exhibited, and polymerizing reaction is conducted in this state, and (5) a counter electrode (cathode) is provided.

Next, materials constituting the light-emitting device according to the invention will be described.

The compound represented by formula (1) is preferably disposed in a layered fashion between a pair of corresponding transparent electrodes. That is, it is preferred that a layer formed from the compound represented by formula (1) be provided between a pair of opposing transparent electrodes. Here, the material used to form the device may be the compound represented by formula (1) alone, or a mixture of the compound represented by formula (1) and other material(s).

In a case of using the liquid crystalline compound in a mixture with other material(s), the mixture may contain a polymeric medium, a spacer such as a particulate material/a sealing agent etc., orientation-controlling agent, other liquid crystalline compound, for example, 4-cyano-4'-pentylbiphenyl, etc.), polymerization initiator, crosslinking agent and the like.

The polymeric medium can be incorporated as a binder and the granulated substance or sealing agent etc. can be incorporated as a spacer. Examples of the polymeric medium include, for example, an acrylic polymer such as PMMA, an imide polymer such as fluorinated polyimide, or polycarbonate.

Examples of the granulated substance include glass beads, plastic beads and alumina beads, as well as crosslinked transparent cured resins which is insoluble in a solvent used for forming the coating solution of the light-emitting layer.

The sealing agent may include a epoxy resin, a curing agent a thickener and the like, and can cause a reaction and curing by dissolving the curing agent dispersed in the sealing agent.

A solvent that dissolves the compound represented by the formula (1) alone or as a mixture thereof may be used. The solvent is not particularly restricted and may include, for example, an ester solvent such as ethyl acetate, a ketone solvent such as methyl ethyl ketone, an ether solvent such as tetrahydrofuran, a halogen solvent such as chloroform and dichloromethane, or a solvent such as cyclohexanone and dimethyl formamide, as well as a mixed solvent thereof. The concentration of the solution is, preferably, from 3 to 30% by weight and, particularly preferably, from 3 to 10% by weight.

Then, a method of coating the solution of the compound represented by formula (1) alone or as a mixture obtained as described above on a transparent electrode substrate is to be described.

As the coating method, a known method, for example, a curtain coating method, extrusion coating method, roll coating method, spin coating method, dip coating method, bar coating method, spray coating method, slide coating method, or printing coating method can be adopted.

Preferred examples of the substrate to be coated include a transparent substrate such as glass, a polymeric film, or a reflection plate that has a transparent electrode layer (anode) . An orientation film, an insulative film, or the like may also be optionally disposed on the substrate. As the orientation film, polyimide, polyvinyl alcohol or PEDOT/PSS (poly-3,4-ethylenedioxythiophene/polystyrene sulfonic acid) type orientation film is preferably used but it is not particularly limited thereto. The insulative film may or may not be used and, in the case where the insulative film is used, preferred examples include an insulation film of polyimide type or polyvinyl alcohol.

Further, the surface state of the substrate can be provided with hydrophilicity by applying a surface treatment.

As the polymeric film used for the substrate, those films of excellent transparency and smoothness may be used. Examples thereof include polyesters such as triacetyl cellulose and polybutylene terephthalate, heat resistant resin such as epoxy resin, phenol resin, polyimide, polycarbonate, polysulfone, polyether sulfone, polyetherimide, polyamino acid ester, and aromatic polyamide, vinyl polymers such as polystyrene, polyacrylate ester, polymethacrylate ester, polyacrylamide, polyethylene and polypropylene, fluorine-containing resin such as polyvinylidene fluoride, and those formed of modified products thereof can be used. Particularly, the triacetyl cellulose film is preferably used in view of its excellent transparency and because it has no optical anisotropy. Films of thickness of from 5 to 1000 µm are usually suitable for use.

The material for the transparent electrode (anode) used in the invention may be known materials such as tin oxide, ITO (Indium Tin Oxide), or IZO (Indium Zinc Oxide), and a thin film of metal such as gold or platinum having large work function may also be used. Further, organic materials such as polyaniline, polythiophene, polypyrrole or derivatives thereof can also be used. Further, transparent conductive films, for example those described specifically in "New Development of Transparent Conductive Film" (Supervised by Yutaka Sawada, published from CMC, in 1999), can also be applied to the invention. Among them, ITO or IZO is preferred in a case of forming a film, particularly, at a low temperature of 150°C or lower. The low temperature film formation is important when a plastic substrate of low heat resistance is used.

Next, a polymerizing reaction for obtaining a polymer of the compound represented by formula (1) will be described.

In order to obtain the polymer, a light (for example, ultraviolet light) is irradiated on a thin film containing the compound represented by formula (1) obtained by the method described above, thereby producing a crosslinked film (polymer). In the polymerizing reaction, when a polymerization initiator such as AIBN is contained, the polymerizing reaction proceeds more easily. However in a case where the polymerizing reaction proceeds sufficiently without the polymerization initiator, the polymerization initiator is not particularly necessary. Further, heat may be applied appropriately depending on the requirement.

The light source used for the light irradiation is not particularly limited and a light-emitting diode, UV-light or laser light is used. Among these ultraviolet light or ultraviolet laser light is preferred because they allow easy polymerization of polymerizable groups.

The wavelength used for the light irradiation is not particularly limited, with a wavelength of from 150 to 500 nm being generally used. Of these, 200 to 350 nm is preferred as this allows easy polymerization of polymerizable groups.

While the time duration for light irradiation depends on the kind of compound represented by formula (1) and is not particularly restricted, the irradiation may be performed for a duration of from 10 s to 10 min, with irradiation of from 30 s to 3 min being preferred as this duration is necessary and sufficient for the polymerization and suppresses reactions other than the polymerization that are unnecessary.

The polymerization initiator can be selected from known polymerization initiators in accordance with the compound represented by formula (1).

In a case where the compound represented by formula (1) exhibits liquid crystallinity, it is preferred to conduct polymerizing reaction by the same method as described above at a temperature where the compound represented by formula (1) exhibits liquid crystallinity from the viewpoint of high extraction efficiency and application in a polarization light-emitting device as described above.

Further, it is preferred that the layer formed from the compound represented by formula (1) is a layer formed by polymerization at a temperature where the compound represented by formula (1) exhibits liquid crystallinity and in a state where molecules of the compound represented by formula (1) are oriented uniaxially.

The polymerizing reaction can also be conducted as described above in a state of applying an external electric field. Particularly, in a case where the compound represented by formula (1) exhibits liquid crystallinity, it is preferred to apply the external electric field at a temperature where the compound is in the liquid crystal phase so that a device having a high order parameter can be prepared.

Then, providing the counter electrode (cathode) will be described.

The counter electrode (cathode) may be formed by disposing a glass or polymeric film having a transparent electrode made of a material such as ITO on an organic layer (light-emitting layer), or a metal electrode may be disposed directly by a vacuum vapor deposition method on the organic layer, or on an electron transportation layer. Alternatively, the counter electrode (cathode) may be a transparent electrode made of a material such as ITO further having an orientation layer (orientation film) formed.

In a case of providing a metal electrode as the counter electrode (cathode), it is preferred to use an alkali metal such as Li, K, or Ce or an alkaline earth metal such as Mg or Ca having a low work function as the cathode material, in view of their electron injection properties. Further, stable and hard-to-oxidize material such as Al is also preferred. To achieve both stability and the electron injection properties, a layer may contain two or more kinds of materials. Such materials are described specifically, for example, in JP-A Nos. 2-15595 and 5-121172. Among them, aluminum alone, or an alloy or mixture mainly comprising aluminum and containing 0.01 to 10% by weight of an alkali metal or alkaline earth metal is particularly preferred.

The light-emitting device according to the invention may have a single light-emitting layer formed from the compound represented by formula (1), or may have several organic layers including this kind of light-emitting layer, in either case being situated between a pair of transparent electrodes (an anode and cathode).

In a case where the device has a structure having plural organic layers, there may be, in addition to the light-emitting layer, a hole injection layer, a hole transportation layer, an electron injection layer, an electron transportation layer, and a protective layer, and each of the layers described above may have another function.

Various materials can be used for forming each of the layers respectively. Each of the organic layers in the device having plural organic layers will be described.

The material for the hole injection layer and the hole transportation layer, may be any material as long as it has the function of injecting holes from the anode, a function of transporting holes, or a function of shielding electrons injected from the cathode. Specific examples of them include conductive polymeric oligomers and polymers such as carbazole, imidazole, triazole, oxazole, oxadiazole, polyarylalkane, pyrazoline, pyrazolone, phenylenediamine, arylamine, amino substituted chalcon, styrylanthracene, fluorenone, hydrazone, stylbene, silazane, aromatic tertiary amine compound, styrylamine, aromatic dimethylidene compound, porphyrin compound, polysilane compound, poly(N-vinylcarbazole), aniline copolymer, thiophene oligomer and polymer, and polythiophene, as well as carbon films or derivatives of those described above.

The thickness of the hole injection layer or the hole transportation layer depends on the material and is not limited particularly but usually from 1 nm to 5 µm is preferable, from 5 nm to 1 µm is more preferable, and from 10 nm to 500 nm is still more preferable.

The hole injection layer or the hole transportation layer may have a single-layer structure comprising one or more of the materials described above, or a multilayer structure having several layers of identical or different composition.

As the method of forming the hole injection layer or the hole transportation layer, a vacuum vapor deposition method or LB method, an ink jet method, a printing method, a transfer method, a method of dissolving or dispersing the hole injection material or the hole transportation material into a solvent and coating the same (for example, spin coating method, casting method or dip coating method) is used. In the coating method, the material can be dissolved or dispersed together with a resin ingredient. The resin ingredient includes polyvinyl chloride, polycarbonate, polystyrene, polymethyl methacrylate, polyester, polysulfone, polyphenylene oxide, polybutadiene, poly(N-vinylcarbazole), hydrocarbon resin, ketone resin, phenoxy resin, polyamide, ethyl cellulose, vinyl acetate, ABS resin, polyurethane, melamine resin, unsaturated polyester resin, alkyd resin, epoxy resin, and silicon resin.

The material for the electron injection layer or the electron transportation layer may be any material having a function of injecting electrons from the cathode, a function of transporting electrons or a function of blocking holes obtained by injection from the anode may be used. Specific examples include various metal complexes typically represented by metal complexes of triazole, triazine, oxazole, oxadiazole, aromatic tetracarboxylic acids anhydrides such as of fluorenone, anthraquinodimethane, anthrone, diphenylquinone, thiopyrane dioxide, carbodiimide, fluorenylidene methane, distyrylpyrazine, naphthalene or perylene, and phthalocyanine or 8-quinolinole derivatives, and metal complexes having metal phthalocyanine, benzooxazole or benzothiazole as ligands, as well as derivatives thereof.

The thickness of the electron injection layer or the electron transportation layer depends on the material and is not limited particularly, but usually from 1 nm to 5 µm is preferable, from 5 nm to 1 µm is more preferable, and from 10 nm to 500 nm is still more preferable.

The electron injection layer or the electron transportation layer may be a single layer structure comprising one or more of the materials described above, or a multilayer structure comprising plural layers each of identical composition or different compositions.

The method of forming the hole injection layer or the hole transportation layer may be a vacuum vapor deposition method or LB method, an ink jet method, a printing method, a transfer method, or a method of dissolving or dispersing the hole injection material or the hole transportation material into a solvent and coating the same (spin coating method, casting method, dip coating method, etc.). In the coating method, the material can be dissolved or dispersed together with a resin ingredient. The resin ingredients given for the case of the hole injection and transportation layers are applicable here as well.

Next, the light-emitting device according to the invention including the light-emitting layer will be described with reference to the drawings, but the invention is not restricted thereto.

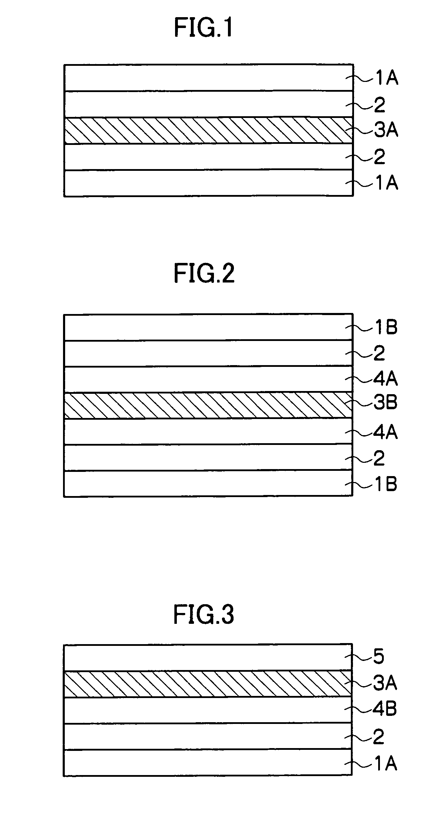

Fig. 1 is a schematic view showing a cross section of an embodiment of a light-emitting device according to the present invention. Fig. 1 depicts a glass substrate 1A, a transparent electrode 2 and a light-emitting layer 3A, and the light-emitting layer 3A is formed by injecting a compound represented by the formula (1) or (2) (Compound 2) into a transparent electrode cell by a capillary force method and irradiating of a ultraviolet light. As the transparent electrode 2, an ITO electrode formed by vapor deposition on the substrate 1A is preferred. Particularly, a case in which the substrate 1A is a glass substrate and the transparent electrode 2 is an ITO electrode is most preferred.

Fig. 2 is a schematic view showing a cross section of another embodiment of a light-emitting device according to the present invention. Fig. 2 depicts a flexible substrate 1B, a transparent electrode 2, a light-emitting layer 3B, and an orientation film 4A (orientation layer). The light-emitting layer 3B contains a polymer of a liquid crystalline compound, the polymeric medium described above, and glass beads, etc. as a spacer. The transparent electrode 2 is identical with that in Fig. 1.

Fig. 3 is a schematic view showing a cross section of still another embodiment of a light-emitting device according to the invention. Fig. 3 depicts a glass substrate 1A, a transparent electrode 2, a light-emitting layer 3A, an orientation layer 4B, and a metal electrode 5. The glass substrate 1A, the transparent electrode 2 and the light-emitting layer 3A are identical with those in Fig. 1.

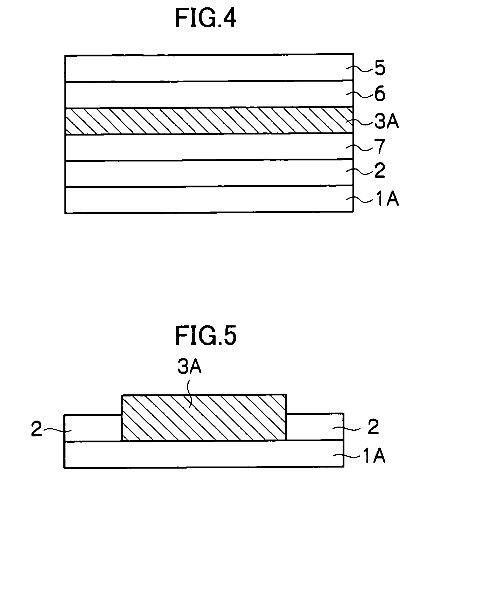

Fig. 4 is a schematic view showing a cross section of a further embodiment of a light-emitting device according to the present invention. Fig. 4 depicts a glass substrate 1A, a transparent electrode 2, a hole transportation layer 7, a light-emitting layer 3A, an electron transportation layer 6, and a metal electrode 5.

Fig. 5 is a schematic view showing a cross section of a still further embodiment of a light-emitting device according to the present invention. Fig. 5 depicts a glass substrate 1A, a transparent electrode 2, a light-emitting layer 3A, and an electron transportation layer 6.

### EXAMPLES

The present invention is more specifically described by way of examples but the invention is not restricted to such examples.

### Example 1

A light-emitting device shown in Fig. 1 was prepared as described below.

The compound 2 was injected by a capillary force method in a cell in which 1.1 mm-thick glass plates which were each provided with ITO transparent electrodes of 30 nm thickness were arranged and bonded so as to face each other across a 2 µm gap therebetween(transparent electrode cell, manufactured by EHC Co.). Then, the cell was irradiated by a ultraviolet light (350 nm, 300 W) for 120 sec to prepare a crosslinked film.

When a DC voltage (60 V) was applied to the ITO electrode, the device emitted light at a brightness of 10 cd/m² or more.

### Example 2

A light-emitting device shown in Fig. 3 was prepared as described below.

At first, after subjecting a glass plate of 1.1 mm thickness having a transparent ITO electrode of 30 nm thickness formed thereon to a ozone-hydrophilic treatment, an aqueous solution of PEDOT/PSS (poly-3,4-ethylenedioxy thiophene/polystyrene sulfonic acid) was spin coated, thus becoming a conductive orientation film, and dried in vacuum at 120°C for 10 hours (thickness of orientation film: 150 nm) . Then, the orientation film was subjected to a rubbing treatment. Then, the compound 2 was spin coated on the surface, thus forming a thin film (thickness: 200 nm). This was heated to liquid crystal phase temperature and, in this state was irradiated by a ultraviolet-light (350 nm, 300 W) for 120 sec to prepare a crosslinked film. Further, after vapor depositing lithium fluoride to a thickness of 5 nm, aluminum was vapor deposited to a thickness of 500 nm to prepare a light-emitting device.

When a DC voltage (11 V) was applied between the transparent ITO electrode and the aluminum electrode, the device emitted light at 440 cd/m² (room temperature). When the light emission intensity under room temperature and under heating at 80°C was compared, hardly any lowering of the emission strength due to heating was observed.

### Example 3

The light-emitting device shown in Fig. 4 was prepared as described below.

After vapor depositing TPD (N,N'-diphenyl-N,N'-di(m-tolyl)-benzidine) to thickness of 40 nm, the compound 2 to thickness of 30 nm, Alq (tris (8-hydroxyquinolinate) aluminum) to thickness of 30 nm, lithium fluoride to thickness of 5 nm on a glass plate of 1.1 mm thickness on which was formed a transparent ITO electrode of 30 nm thickness, aluminum was vapor deposited to 500 nm to prepare a light-emitting device. When a DC voltage (11 V) was applied between the transparent ITO electrode and the aluminum electrode, the device emitted light at 850 cd/m².

### Example 4

The light-emitting device shown in Fig. 5 was prepared as described below.

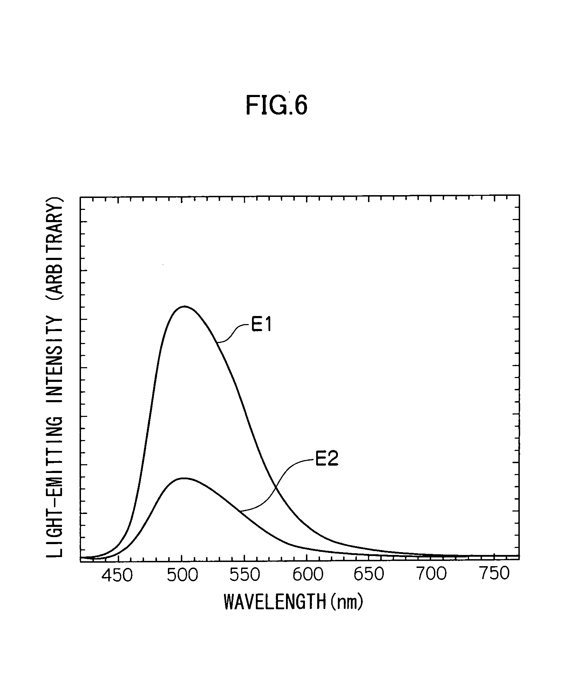

Two linear transparent ITO electrodes each of 30 nm thickness and 100 µm width was were formed (distance between the two linear transparent ITO electrodes: 10 µm) on a glass plate of 1.1 mm thickness. A 10 wt% chloroform solution of the compound 2 was spin coated on the substrate and dried sufficiently in vacuum. Then, when a voltage at 50 V was continuously applied between the two transparent ITO electrodes for 10 min, the device emitted a green light. The emission spectra in the horizontal direction and the vertical direction (with respect to the polarization axis) after passing through a polarization plate were as shown in Fig. 6. E1 is a plotted curve of the polarization brightness in the horizontal direction with respect to the polarization axis (vs wavelength), and E2 is a plotted curve of the polarization brightness in the vertical direction with respect to the polarization axis (vs: wavelength). When the order parameter was calculated based on the spectrum, it was 0.40.

According to the invention, a light-emitting device which is stable with respect to heat, can be produced easily and, further, possesses excellent light emitting characteristics and polarization characteristics can be provided.

According to the invention, the device can be manufactured without using a vapor deposition apparatus or the like and, hence, can be produced easily. Further, the light-emitting layer is three dimensionally crosslinked and stable with respect to heat. Further, a polarization light-emitting device can be prepared by fixing the liquid crystal orientation through crosslinking. Further, since a light-emitting layer can be disposed also between a pair of transparent electrodes, a both-side light-emitting body can be manufactured.

## Claims

1. A light-emitting device comprising a layer formed from a compound represented by formula (1): 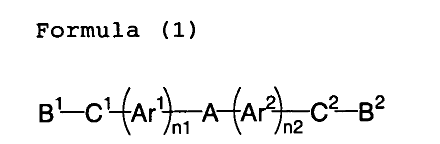 wherein A represents a heterocyclic ring having at least one heteroatom, and Ar¹ and Ar² each independently represent an aromatic ring, provided that A, Ar¹, and Ar² each may have a substituent; B¹ and B² each independently represent a polymerizable substituent; C¹ and C² each independently represent a linear, branched, or cyclic linking group having 1 to 20 carbon atoms, and one or more -CH₂- in the linking group may be substituted with -O-, -CO-, -NH-, -NR-, -CH=CH-, or -C ≡C- provided that the one or more -CH₂- are not adjacent to a heteroatom; R represents an alkyl group having 1 to 20 carbon atoms, and one or more -CH₂- in the alkyl group may be substituted with -O-, -CO-, -CH=CH-, or -C≡C- provided that the one or more -CH₂- are not adjacent to a heteroatom; and n1 and n2 each independently represent an integer of 0, 1, or 2 provided that n1 and n2 do not both represent 0 at the same time.

2. The device of claim 1, wherein A is selected from the group consisting of thiophene-2,5-diyl, thiazole-2,5-diyl, thiadiazole-2,5-diyl, pyridine-2,5-diyl, pyrimidine-2,5-diyl, pyrazine-2,5-diyl, and pyridazine-3,6-diyl.

3. The device of claim 1, wherein A is thiophene-2,5-diyl or thiazole-2,5-diyl.

4. The device in any one of claims 1 to 3, wherein Ar¹ and Ar² each independently represent 1,4-phenylene, 2,6-naphthalene, thiophene-2,5-diyl or thiazole-2,5-diyl.

5. The device in any one of claims 1 to 4, wherein C¹ and C² each independently represent a linear alkyl group having 4 to 12 carbon atoms or a linear alkyloxy group.

6. The device in any one of claims 1 to 5, wherein the compound represented by formula (1) is a compound represented by formula (2): 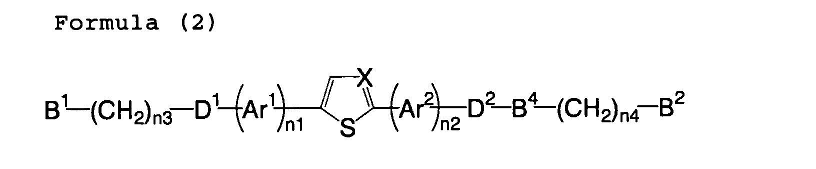 wherein X represents a nitrogen atom or CH; Ar¹ and Ar² each independently represent an aromatic ring; B¹ and B² each independently represent a polymerizable substituent; n1 and n2 each independently represent an integer of 0, 1, or 2 provided that n1 and n2 do not both represent 0 at the same time; n3 and n4 each independently represent an integer from 1 to 20; D¹ and D² each independently represent a single bond, -O-, -COO-, -OCO-, -NH-, -NR-, -NRCO-, -CONR-, -NHCO-, or -CONH-; R represents an alkyl group having 1 to 20 carbon atoms, and one or more -CH₂- in the alkyl group may be substituted with -O-, -CO-, -CH=CH-, or -C≡C- provided that the one or more -CH₂- are not adjacent to a heteroatom; and B⁴ represents a single bond or an alkylene group having 2 to 10 carbon atoms which may be further substituted with an alkyl group.

7. The device of claim 6, wherein Ar¹ and Ar² each independently represent 1,4-phenylene, 2,6-naphthalene, thiophene-2,5-diyl or thiazole-2,5-diyl.

8. The device in any one of claims 1 to 7, wherein the compound represented by formula (1) is a compound exhibiting liquid crystallinity.

9. The device in any one of claims 1 to 8, wherein the layer formed from the compound represented by formula (1) is provided between a pair of opposing transparent electrodes.

10. The device of claim 9, wherein the layer formed from the compound represented by formula (1) is a layer formed by polymerization at a temperature where the compound represented by formula (1) exhibits liquid crystallinity and in a state where molecules of the compound represented by formula (1) are oriented uniaxially.
